# EUROPEAN PATENT APPLICATION

(11) **EP 4 841 843 A1**
(43) Date of publication of application: **18.11.2026**
(21) Application number: 26178419.3
(22) Date of filing: 13.05.2026
(51) Int. Cl.: H02H 5/10, G01R 31/54, H02H 3/34, G01R 31/08

(54) **SYSTEMS AND METHODS FOR DETECTING AND ALERTING AN OPEN CIRCUIT NEUTRAL FOR INTELLIGENT RACK POWER DISTRIBUTION UNITS**

(30) Priority: 13.05.2025 US 202563805001 P; 24.04.2026 US 202619657197
(71) Applicant: Vertiv Corporation, Westerville, OH 43082 (US)
(72) Inventor: FERGUSON, Kevin, R., Westerville 43082 (US); COOPER, Scott, Westerville 43082 (US)
(74) Representative: Cousens, Nico

(57) **Abstract**

A system for detecting an open circuit neutral condition in a power distribution unit. The system works by collecting a high resolution times series data for input phase voltages; calculating a new time series of magnitude of a voltage zero sequence based on the high resolution times series data; calculating at least one parameter of the voltage zero sequence; determining whether the at least one parameter is within a range of at least one predetermined parameter; determining whether the at least one parameter is within the range of the at least one predetermined parameter for a defined time interval in response determining that the at least one parameter is within the range of the at least one predetermined parameter for the defined time interval; and detecting an open circuit neutral condition.

## Description

### FIELD

The following description relates generally to power distribution units (PDUs), and more particularly, to systems and methods for detecting and alerting an open circuit neutral condition in intelligent rack PDUs.

### BACKGROUND

Rack-mounted power distribution units (PDUs) are widely used in data centers, telecommunications facilities, and other critical infrastructure environments to distribute electrical power to multiple devices. Such PDUs may be susceptible to open circuit neutral conditions. An open circuit neutral occurs when the neutral conductor is disconnected or fails, causing unpredictable voltage fluctuations that can harm sensitive electronic equipment.

### SUMMARY

An aspect of the disclosed embodiments includes a system for detecting an open circuit neutral condition in a power distribution unit (PDU). The system comprises a processor and a memory including instructions that, when executed by the processor, cause the processor to: collect a high resolution times series data for input phase voltages; calculate, by a voltage sensor, a new time series of magnitude of a voltage zero sequence based on the high resolution times series data; calculate, by the processor, at least one parameter of the voltage zero sequence; determine, by the processor, whether the at least one parameter is within a range of at least one predetermined parameter; in response to a determination that the at least one parameter is within the range of the at least one predetermined parameter, determine, by the processor, whether the at least one parameter is within the range of the at least one predetermined parameter for a defined time interval; in response to a determination that the at least one parameter being is within the range of the at least one predetermined parameter for the defined time interval, detect, by the processor, an open circuit neutral condition; and energize, by the processor, a voltage coil of a shunt trip circuit breaker powering a load.

These and other aspects of the present disclosure are disclosed in the following detailed description of the embodiments, the appended claims, and the accompanying figures.

### BRIEF DESCRIPTION OF THE DRAWINGS

These and other aspects, features and advantages will become readily apparent to those skilled in the art in view of the following detailed description of presently preferred embodiments and best mode, appended claims, and accompanying drawings.
FIGS. 1A and 1B generally illustrate a closed circuit path and an open circuit path in an open circuit neutral, according to the principles of the present disclosure.
FIG. 2 generally illustrates waveforms of a three-phase wye system with the open circuit path, and more specifically, the change in magnitude of the waveforms of the three-phase wye system at the open circuit neutral condition, according to the principles of the present disclosure.
FIG. 3 generally illustrates a block diagram of a processor-based computer system, according to the principles of the present disclosure.
FIG. 4 is a flow diagram generally illustrating a method for detecting and altering open circuit neutral for intelligent PDUs, according to the principles of the present disclosure.

### DETAILED DESCRIPTION OF PREFERRED EMBODIMENTS

The following discussion is directed to various embodiments of the disclosure. Although one or more of these embodiments may be preferred, the embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment.

The present specification and accompanying drawings disclose one or more embodiments that incorporate the features of the present disclosure. The scope of the present disclosure is not limited to the disclosed embodiments. The disclosed embodiments merely exemplify the present disclosure, and modified versions of the disclosed embodiments are also encompassed by the present disclosure. Embodiments of the present disclosure are defined by the claims appended hereto.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In the discussion, unless otherwise stated, adjectives such as "substantially," "approximately," and "about" modifying a condition or relationship characteristic of a feature or features of an embodiment of the disclosure, are understood to mean that the condition or characteristic is defined to be within tolerances that are acceptable for operation of the embodiment for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same embodiment or implementation unless described as such.

Numerous exemplary embodiments are described as follows. It is noted that any section/subsection headings provided herein are not intended to be limiting. Embodiments are described throughout this document, and any type of embodiment may be included under any section/subsection. Furthermore, embodiments disclosed in any section/subsection may be combined with any other embodiments described in the same section/subsection and/or a different section/subsection in any manner.

As described, rack-mounted PDUs are widely used in data centers, telecommunications facilities, and other critical infrastructure environments to distribute electrical power to multiple devices. Detecting an open circuit neutral condition (e.g., a fault that can lead to severe imbalances, equipment damages) allows operators to remain aware of critical power issues before device malfunctions or they sustain damage.

Accordingly, systems and methods, such as those described herein, configured to detect an open circuit neutral condition in intelligent PDUs, to provide an alert indicating the open circuit neutral condition, and to energize a shunt trip circuit breaker, may be desirable.

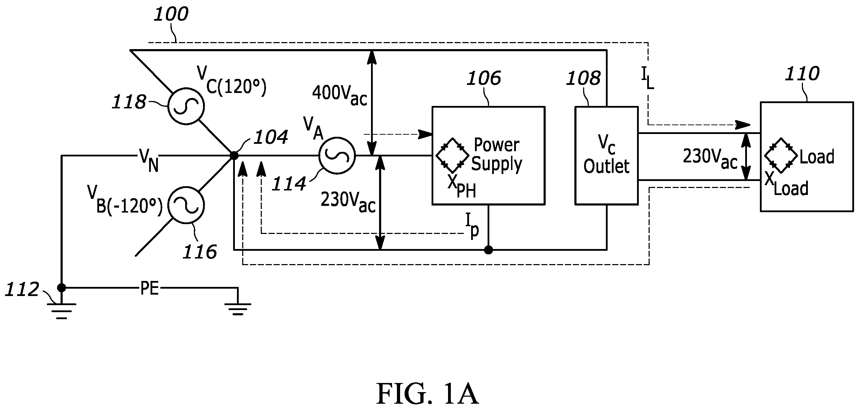

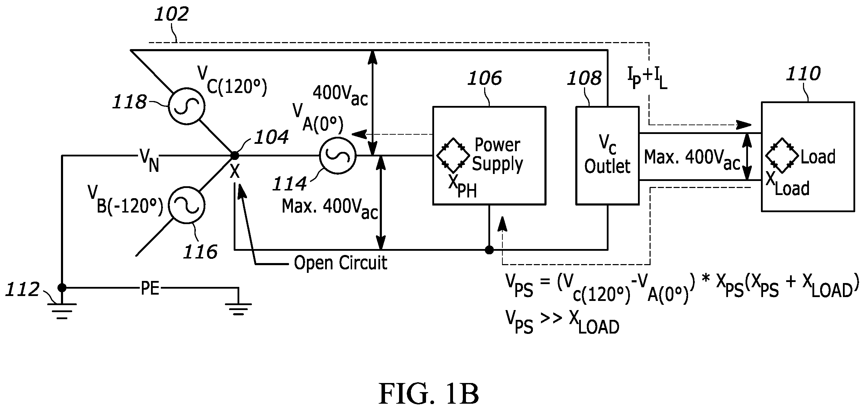

In some embodiments, and as is generally described with respect to FIGS. 1A and 1B, a closed circuit path 100 and an open circuit path 102 in an open circuit neutral 104 may include a three-phase wye system 104, a power supply 106, a voltage outlet 108, a load 110, and a ground 112. The three-phase wye system 104 comprises Phase A 114, Phase B 116, and Phase C 118. Phase A 114 is electrically coupled to the power supply 106 and Phase C is electrically coupled to the voltage outlet 108. The three-phase wye system 104 is located outside the PDU.

The three-phase wye system 104 is configured to provide evenly distributed power to the power supply 106. If the three-phase wye system 104 is balanced with no harmonic distortion, the line voltage *V_{L}* and phase voltage *Vₚ* relationship are $\sqrt{3} {V}_{L} ≡ {V}_{p} ≡ {V}_{A} ≡ {V}_{B} ≡$ *V_{C}* when neutral is at some equipotential as the power source, then *V*₀ (*s*) = 0. The open circuit neutral condition potential is displaced from the power source equipotential according to the weighted average of the three-phase loading. If the three-phase loading is unbalanced, then the open circuit neutral potential shifts towards the phase voltage of the load having proportionally the largest current draw *Iₘₐₓ.* The loads with a different phase voltage will have their neutral elevated up to the same phase voltage as the phase for *Iₘₐₓ,* producing up to the line voltage *V_{L}* in the worst unbalanced scenario, i.e., $\sqrt{3} \times {V}_{p}$ across their loads.

The power supply 106 is electrically coupled to the three-phase wye system 104, and the Phase A 114. The power supply 106 is located within the PDU. The power supply 106 is configured to receive power from the three-phase wye system 104 and configured to deliver power to electronic components associated with the PDU such as, but not limited to, one or more processors associated with the PDU. The voltage outlet 108 is electrically coupled between Phase C 118, the three-phase wye system 104, and the load 110. The voltage outlet 108 is located within the PDU. The voltage outlet 108 is configured to receive power from the three-phase wye system 104 and supply power to the load 110. The load 110 is configured to deliver power to user device(s) such as, but not limited to a server, storage device, networking gear, cooling systems, large motors, etc.

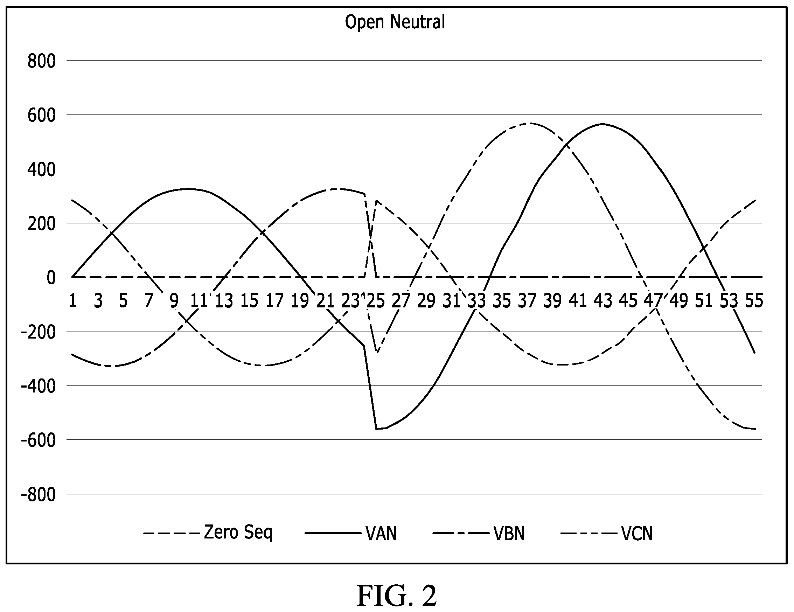

As shown in FIG. 1A, the closed circuit path 100 is in a normal operating condition. The open circuit path 104 is in an open circuit neutral (fault) condition occurs when the neutral conductor is disconnected or fails, disrupting the normal return path for current in the three-phase wye system 104 (depicted in FIG. 1B). In some embodiments, the voltages rises across the voltage outlet 108 in response to the voltage across the load 110 being unbalanced or above a voltage threshold. A voltage-neutral disconnect condition may occur when a neutral wire is loose or insufficiently tightened at a terminal block, or when a three-phase electrical system is incorrectly connected by a customer. In response to the voltage rising across the voltage outlet 108, the power supply protection system disconnects the neutral and thereby protects the power supply 106 from voltages above a voltage threshold and associated damage. FIG. 2 depicts waveforms of the three-phase wye system 104 with the open circuit path 104, and more specifically, the change in magnitude of the waveforms of the three-phase wye system 104 at the open circuit neutral condition.

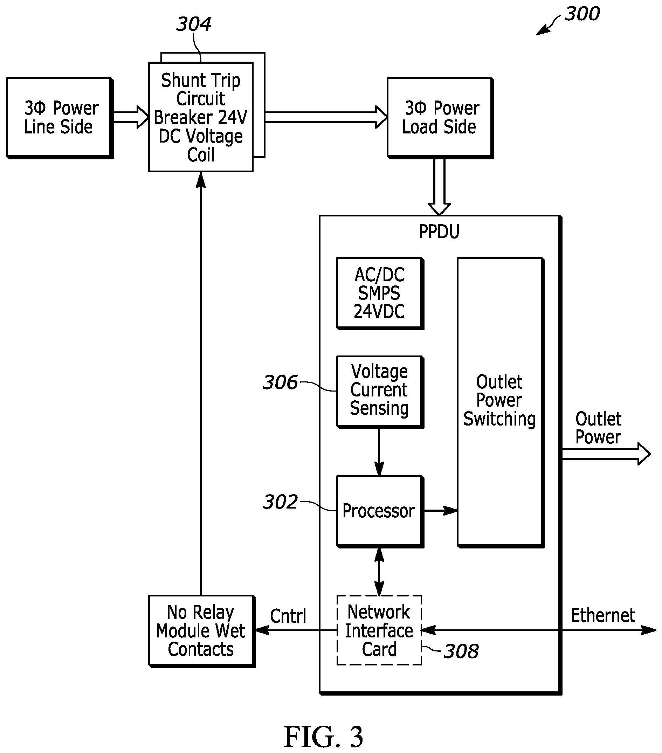

FIG. 3 is an example block diagram of a processor-based computer system 300. As shown in FIG. 3, processor-based computer system 300 includes one or more processors 302, a memory, a shunt trip circuit breaker 304, a voltage sensor 306, and a network interface card 308. The memory, the shunt trip circuit breaker 304, the voltage sensor 306, and the network interface card 308 are coupled to the processor 302. The processor 302 is an electrical and/or optical circuit implemented in one or more physical hardware electrical circuit device elements and/or integrated circuit devices (semiconductor material chips or dies) as a central processing unit (CPU), a microcontroller, a microprocessor, and/or other physical hardware processor circuit. The processor 302 may execute program code stored in a computer readable medium. The memory includes read only memory (ROM) and random access memory (RAM). A basic input/output system (BIOS) is stored in ROM.

The memory includes instructions that, when executed by the processor 302, causes the processor 302 to perform various aspects of the systems and methods described herein. For example, the processor 302 may be configured to detect and alert the open circuit neutral condition for intelligent rack-PDU. In some embodiments, the voltage sensor 306 collects a high resolution times series data for input phase voltages: *V_{A}*(*s*),*V_{B}*(*s*),*V_{C}*(*s*)*.* The high resolution time series data are instantaneous voltages of the voltage waveform. The processor 302 may collect a new times series of magnitude of voltage zero sequence *V*₀(*s*) per the high resolution times series data. The processor 302 may calculate other parameters of *V*₀(*s*), including, but not limited to, a filtered response *V_{f}*(*s*) = *H*(*s*)*V*₀(*s*), rate of change, i.e., first order difference $\frac{{dV}_{0}}{dt} \left(s\right)$*,* and vector direction. In some embodiments, the processor 302 may compare the other parameters of *V*₀(*s*) to respective thresholds or bounds. In response to the logical criteria of all threshold breaches being met and has persisted for a set time interval, the processor 302 may signal an open circuit neutral condition. The processor 302 may, in parallel or substantially in parallel with signaling the open circuit neutral condition, cause, using hardware, a voltage coil of the shunt trip circuit breaker 304 powering the system to energize. The hardware may include a relay and power supply circuit tethered to and/or in communication with the processor 302 via a port interface at the network card 308. In response to the voltage coil being energized for a period, the shunt trip circuit breaker 304 may self-trip, i.e., open, all associated poles, and disconnect operating power from the processor 302 and/or the system 300 and connected equipment. In some embodiments, FIG. 3 further includes a relay module contacts block operatively coupled between the processor 302 and the shunt trip circuit breaker 304. The relay module contacts block may provide a controllable switching interface for selectively coupling a control voltage from an AC/DC switched-mode power supply to the voltage coil of the shunt trip circuit breaker 304. In this manner, the processor 302 may issue a control signal that causes the relay module contacts block to close a contact path and deliver the control voltage to the shunt trip circuit breaker 304, thereby initiating a trip event. In some embodiments, the relay module contacts block may also be connected to the network interface card 308 to enable communication, coordination, or control associated with protective tripping, outlet power control, status reporting, or remote monitoring in response to detection of an open circuit neutral condition.

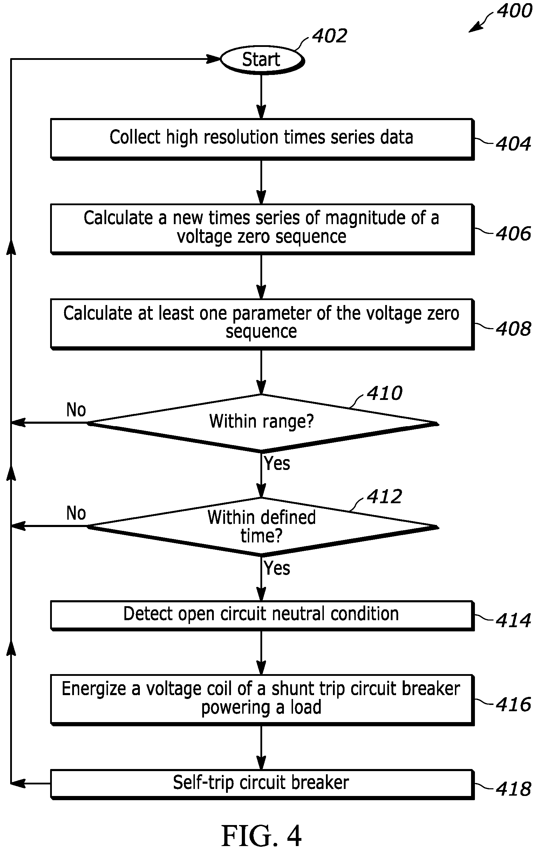

FIG. 4 is an example of a method 400 of detecting and altering the open circuit neutral for rack-mounted PDUs. In some embodiments, one or more process blocks of FIG. 4 may be performed by the processor 302. The method 400 may be executed by one or more processors disclosed here, and instructions for executing the method 400 can be stored in memory.

As shown in FIG. 4, the method 400 begins at 402. At 404, the method 400 includes collecting, by the voltage sensor 306, high resolution time series data for input phase voltages.

At 406, the method 400 includes calculating, by the processor 302, a new times series of magnitude of the voltage zero sequence *V*₀ (*s*) based on the high resolution times series data from 404.

At 408, the method 400 includes calculating, by the processor 302, at least one parameter of the voltage zero sequence *V*₀(*s*)*.* The parameters of the voltage zero sequence *V*₀(*s*) may include, but is not limited to, a filtered response, a rate of change, a first order difference, and vector direction.

At 410, the method 400 includes determining, by the processor 302, whether the parameter of the voltage zero sequence *V*₀ (*s*) is within a range of at least one predetermined parameter. The predetermined parameter may include, but is not limited to, a threshold value. If yes, the method 400 continues to 412. If no, the method 400 continues to 404.

At 412, the method 400 includes determining, by the processor 302, whether the parameter of the voltage zero sequence *V*₀(*s*) is within the range of the at least one predetermined parameter for a defined time interval. If yes, the method 400 continues to 414. If no, the method 400 continues to 404.

At 414, the method 400 includes detecting, by the processor 302, the open circuit neutral condition. The method 400 may further include sending, by the network interface card 308, an alert to a remote computing device.

At 416, the method 400 includes energizing, by the processor 302, the voltage coil of the shunt trip circuit breaker 304 powering the load 110. The relay and the power supply 106 are in communication with the voltage coil of the shunt trip circuit breaker 304.

At 418, the method 400 includes tripping, by the processor 302, the shunt trip circuit breaker 304.

In some embodiments, a system for detecting an open circuit neutral condition in a power distribution unit (PDU) includes a processor, and a memory. The memory includes instructions that, when executed by the processor, cause the processor to: collect, by a voltage sensor, a high resolution times series data for input phase voltages; calculate, by the processor, a new time series of magnitude of a voltage zero sequence based on the high resolution times series data; calculate, by the processor, at least one parameter of the voltage zero sequence; determine, by the processor, whether the at least one parameter is within a range of at least one predetermined parameter; in response to a determination that the at least one parameter is within the range of the at least one predetermined parameter, determine, by the processor, whether the at least one parameter is within the range of the at least one predetermined parameter for a defined time interval; in response to a determination that the at least one parameter being is within the range of the at least one predetermined parameter for the defined time interval, detect, by the processor, an open circuit neutral condition; and energize, by the processor, a voltage coil of a shunt trip circuit breaker powering a load.

In some embodiments, a relay and a power supply are in communication with the voltage coil of the shunt trip circuit breaker. In some embodiments, the at least one parameter includes at least one of a filtered response, a rate of change, a first order difference, and vector direction. In some embodiments, the at least one predetermine parameter defines at least one threshold value.

Implementations the systems, algorithms, methods, instructions, etc., described herein can be realized in hardware, software, or any combination thereof. The hardware can include, for example, computers, intellectual property (IP) cores, application-specific integrated circuits (ASICs), programmable logic arrays, optical processors, programmable logic controllers, microcode, microcontrollers, servers, microprocessors, digital signal processors, or any other suitable circuit. In the claims, the term "processor" should be understood as encompassing any of the foregoing hardware, either singly or in combination. The terms "signal" and "data" are used interchangeably.

As used herein, the term module can include a packaged functional hardware unit designed for use with other components, a set of instructions executable by a controller (e.g., a processor executing software or firmware), processing circuitry configured to perform a particular function, and a self-contained hardware or software component that interfaces with a larger system. For example, a module can include an application specific integrated circuit (ASIC), a Field Programmable Gate Array (FPGA), a circuit, digital logic circuit, an analog circuit, a combination of discrete circuits, gates, and other types of hardware or combination thereof. In other embodiments, a module can include memory that stores instructions executable by a controller to implement a feature of the module.

Further, in one aspect, for example, systems described herein can be implemented using a general-purpose computer or general-purpose processor with a computer program that, when executed, carries out any of the respective methods, algorithms, and/or instructions described herein. In addition, or alternatively, for example, a special purpose computer/processor can be utilized which can contain other hardware for carrying out any of the methods, algorithms, or instructions described herein.

Further, all or a portion of implementations of the present disclosure can take the form of a computer program product accessible from, for example, a computer-usable or computer-readable medium. A computer-usable or computer-readable medium can be any device that can, for example, tangibly contain, store, communicate, or transport the program for use by or in connection with any processor. The medium can be, for example, an electronic, magnetic, optical, electromagnetic, or a semiconductor device. Other suitable mediums are also available.

Also disclosed are the following numbered items:
1. A system for detecting an open circuit neutral condition in a three-phase wye electrical distribution network, the system comprising:
   a voltage sensor configured to monitor phase voltages of the three-phase wye electrical distribution network;
   a processor; and
   a memory including instructions that, when executed by the processor, cause the processor to:
      compute, based on the monitored phase voltages, a voltage zero sequence,
      calculate at least one parameter of the voltage zero sequence, wherein the at least one parameter includes at least one of a magnitude, a rate of change, a first-order difference, a filtered magnitude, or a vector direction,
      determine, by the processor, whether the at least one parameter satisfies a predetermined condition indicative of an open circuit neutral condition,
      in response to determining whether the at least one parameter satisfies the predetermined condition, determine, by the processor, that the at least one parameter satisfies the predetermined condition for a defined time interval,
      in response to determining that the at least one parameter satisfies the predetermined condition for the defined time interval, detect, by the processor, the open circuit neutral condition,
      in response to determining the open circuit neutral condition, initiate, by the processor, a protective action.
2. The system of item 1, wherein the protective action includes energizing, by the processor, a voltage coil of a shunt trip circuit breaker powering a load, wherein the shunt trip circuit breaker is electrically connected to the three-phase wye electrical distribution network.
3. The system of item 2, wherein a relay and a power supply are in communication with the voltage coil of the shunt trip circuit breaker.
4. The system of any preceding item, wherein the predetermined condition comprises a magnitude of the voltage zero sequence exceeding a threshold value defined based on a weighted average of loading across the three-phase wye electrical distribution network.
5. The system of any preceding item, wherein calculating the at least one parameter of the voltage zero sequence comprises applying a filter defined by a transfer function to generate a filtered response.
6. The system of any preceding item, wherein determining whether the at least one parameter satisfies the predetermined condition comprises detecting a rise in voltage at a voltage outlet caused by imbalance of a load of the three-phase wye electrical distribution network.
7. The system of any preceding item, wherein the protective action comprises energizing a voltage coil of a shunt trip circuit breaker to remove power from a connected load.
8. The system of any preceding item, wherein the voltage sensor is configured to collect high-resolution time series data for each of the phase voltages at a sampling rate sufficient to detect transient movement of a neutral potential.

The above-described embodiments, implementations, and aspects have been described in order to allow easy understanding of the present disclosure and do not limit the present disclosure. On the contrary, the disclosure is intended to cover various modifications included within the scope of the appended claims, which scope is to be accorded the broadest interpretation to encompass all such modifications as is permitted under the law.

Obviously, many modifications and variations of the present disclosure are possible in light of the above teachings. It is contemplated that all features of all claims and of all embodiments can be combined with each other, so long as such combinations would not contradict one another. It is, therefore, to be understood that within the scope of the appended claims, the system and methods described herein may be practiced otherwise than as specifically described.

## Claims

1. A system (300) for detecting an open circuit neutral condition in a power distribution unit "PDU", the system comprising:
a processor (302); and
a memory including instructions that, when executed by the processor, cause the processor to:
collect (404), by a voltage sensor (306), a high-resolution time series data for input phase voltages,
calculate (406), by the processor, a new time series of magnitude of a voltage zero sequence based on the high-resolution time series data,
calculate (408), by the processor, at least one parameter of the voltage zero sequence;
determine (410), by the processor, whether the at least one parameter is within a range of at least one predetermined parameter,
in response to determining that the at least one parameter is within the range of the at least one predetermined parameter, determine (412), by the processor, whether the at least one parameter is within the range of the at least one predetermined parameter for a defined time interval,
in response to determining that the at least one parameter is within the range of the at least one predetermined parameter for the defined time interval, detect (414), by the processor, an open circuit neutral condition, and
in response to detecting the open circuit neutral condition, energize (416), by the processor, a voltage coil of a shunt trip circuit breaker (304) powering a load.

2. The system of claim 1, wherein a relay and a power supply are in communication with the voltage coil of the shunt trip circuit breaker.

3. The system of claim 1 or 2, wherein the at least one parameter includes at least one of a filtered response, a rate of change, a first order difference, and vector direction.

4. The system of any preceding claim, wherein the at least one predetermined parameter defines at least one threshold value.

5. The system of any preceding claim, wherein the voltage sensor is configured to detect harmonic distortion in at least one of the input phase voltages.

6. The system of any preceding claim, wherein determining whether the at least one parameter is within the range of the at least one predetermined parameter comprises comparing the at least one parameter to a dynamically updated threshold value computed based on historical loading profiles of the PDU.

7. The system of any preceding claim, wherein the instructions, when executed by the processor, further causes the processor to filter the high-resolution time series data using at least one of: a low-pass filter, a moving average filter, an exponential smoothing filter, or a frequency domain filter.

8. The system of any preceding claim, wherein the processor is configured to compute the voltage zero sequence using a weighted averaging technique based on a detected phase imbalance.

9. The system of any preceding claim, wherein calculating the at least one parameter of the voltage zero sequence comprises computing a time derivative of the voltage zero sequence using the high-resolution time series data.

10. A method for detecting an open circuit neutral condition in a three-phase wye electrical distribution network, the method comprising:
collecting (404), by a voltage sensor, high-resolution time series data for input phase voltages of the three-phase wye electrical distribution network;
calculating (406), by a processor, a voltage zero sequence based on the high-resolution time series data;
calculating (408), by the processor, at least one parameter of the voltage zero sequence, wherein the parameter includes at least one of a magnitude, a rate of change, a first order difference, a filtered magnitude, or a vector direction;
determining (410), by the processor, whether the at least one parameter satisfies a predetermined condition indicative of an open circuit neutral condition;
in response to determining that the at least one parameter satisfies the predetermined condition, determining (412), by the processor, whether the at least one parameters satisfies the predetermined condition for a defined time interval;
in response to determining that the at least one parameter satisfies the predetermined condition for the defined time interval, detecting (414), by the processor, the open circuit neutral condition; and
in response to detecting the open circuit neutral condition, initiating, by the processor, a protective action.

11. The method of claim 10, wherein calculating the voltage zero sequence comprises applying a filter defined by a transfer function to generate a filtered response of a voltage zero sequence signal.

12. The method of claim 10 or 11, wherein initiating the protective action comprises energizing a voltage coil of a shunt trip circuit breaker to disconnect power from a load coupled to a power distribution unit.
